# EUROPÄISCHE PATENTSCHRIFT

(11) **EP 2 006 988 B1**
(45) Veröffentlichungstag und Bekanntmachung des Hinweises auf die Patenterteilung: **01.12.2010**
(21) Anmeldenummer: 07010195.1
(22) Anmeldetag: 23.05.2007
(51) Int. Cl.: H02M 7/48, H05K 5/02

(54) **Wechselrichter**
Inverter
Onduleur

(43) Veröffentlichungstag der Anmeldung: 24.12.2008
(73) Patentinhaber: SMA Solar Technology AG, 34266 Niestetal (DE)
(72) Erfinder: Victor, Matthias Dr., 34266 Niesetal (DE); Donth, Andreas, 34295 Edermünde (DE); Häde, Johannes, 36211 Alheim (DE); Laschinski, Joachim, 34134 Kassel (DE); Benn, Alexander, 70435 Stuttgart (DE)
(74) Vertreter: Walther, Walther & Hinz GbR

(56) Entgegenhaltungen:
- EP-A- 0 994 559
- DE-A1- 2 455 689
- GB-A- 2 212 334

## Beschreibung

Die vorliegende Erfindung betrifft einen Wechselrichter für eine PV-Anlage, umfassend ein Gehäuse.

Wechselrichter dienen bei der Nutzung alternativer Energiequellen, wie z. B. PV-Modulen, dazu, Gleichstrom in Wechselstrom umzuwandeln. Ein solcher Wechselrichter weist ein Gehäuse auf, wobei in dem Gehäuse leistungselektronische Bauteile angeordnet sind. Diese leistungselektronischen Bauteile sind vor Umwelteinflüssen, insbesondere Feuchtigkeit, zu schützen. Ein solcher Wechselrichter umfasst nicht nur leistungselektronische Bauteile, sondern darüber hinaus gegebenenfalls eine Vielzahl von Steckern oder Ähnliches, um diesen Wechselrichter AC- und DC-seitig anzuschließen. Häufig genug besitzt ein solcher Wechselrichter auch eine Kommunikationseinheit, beispielsweise in Form eines Displays, die ebenfalls angeschlossen werden muss.

Aus der EP 0 994 559 A2 ist ein Umrichter bekannt, der allerdings nur für den Inneneinsatz gedacht ist, da das Gehäuse u. a. Öffnungen aufweist, durch die Wasser und Schmutz eindringen kann. Der Umrichter besitzt ein einkammeriges Gehäuse sowie einen Steuerkopf, auf den eine Anschlusseinheit und ein Handbediengerät aufgesetzt werden kann.

Aus der DE 24 55 689 A1 ist eine Anordnung zum Verdecken einer Befestigungsschraube des Deckels eines Gehäuses für elektrische Geräte bekannt. Diese Lasche, die der Abdeckung der Schraube dient, ist durch eine weitere Schraube gehalten, so dass die Lasche nur dann abnehmbar ist, wenn diese weitere Schraube entfernt worden ist.

Wechselrichter werden bei der Montage von PV-Anlagen durch den vor Ort tätigen Elektroinstallateur installiert. Zur Installation wird bei bekannten Wechselrichtern das Gehäuse geöffnet, damit der Installateur sich Zugang zu den entsprechenden Steckkontakten verschaffen kann. Da die Montage derartiger Wechselrichter häufig im Freien geschieht, sind die leistungselektronischen Bautelle zumindest für den Zeitraum der Montage und der Installation Umwelteinflüssen ausgesetzt.

Nun ist aber bekannt, dass das Gehäuse des Wechselrichters, in dem die leistungselektronischen Bauteile untergebracht sind, eine hohe Schutzartklasse aufweisen muss, nämlich die IP65, um zu gewährleisten, dass bei Einsatz eines solchen Wechselrichters im Außenbereich die leistungselektronischen Bauteile tatsächlich vor Umwelteinflüssen, und hier insbesondere vor Feuchtigkeit geschützt sind. Darüber hinaus besteht die Gefahr, dass bei Anschlussarbeiten des Elektroinstallateurs an dem Wechselrichter absichtlich oder unabsichtlich Teile der Leistungselektronik beschädigt werden. Auch bei Wartungsarbeiten an der PV-Anlage ist es häufig genug so, dass lediglich der Zugang zu den einzelnen Steckverbindungen gewährleistet sein muss, wenn z. B. PV-Module vom Wechselrichter getrennt werden müssen oder aber AC-seitig eine Trennung vorgenommen werden soll. Das heißt, Zugang zu den leistungselektronischen Bauteilen sollen im Wartungsfall ausschließlich der Hersteller oder von ihm beauftragte Personen haben.

Das heißt, der Erfindung liegt die Aufgabe zu Grunde, einen Wechselrichter zu schaffen, bei dem die leistungselektronischen Bauteile nur zu Anschlussarbeiten nicht unmittelbar zugänglich sind.

Zur Lösung der Aufgabe wird insofern erfindungsgemäß vorgeschlagen, dass das Gehäuse mindestens zwei Gehäusekammern umfasst, die jeweils durch einen gesonderten Deckel verschließbar sind, wobei zunächst der Deckel abgenommen werden muss, bevor die Gehäusekammer geöffnet werden kann, wobei die eine erste Gehäusekammer die leistungselektronischen Bauteile aufnimmt, wobei in die erste Gehäusekammer von zumindest der zweiten Gehäusekammer mindestens eine elektrische Verbindung vorgesehen ist, die eine Schutzartklasse aufweist, die zumindest der der ersten Gehäusekammer entspricht. Hieraus wird deutlich, dass die leistungselektronischen Bauteile des Wechselrichters in einer gesonderten Gehäusekammer untergebracht werden können, wohingegen die Anschlussstecker und die Kommunikationseinheit, beispielsweise in Form eines Displays, in einer zweiten Gehäusekammer untergebracht sind, die gesondert neben der ersten Gehäusekammer im Gehäuse des Wechselrichters angeordnet ist. Insofern ist es auch nicht erforderlich, dass für Anschlussarbeiten der Deckel der Gehäusekammer geöffnet wird, die die leistungselektronischen Bauteile aufnimmt.

Wie bereits an anderer Stelle erläutert, sind die leistungselektronischen Bauteile in der ersten Gehäusekammer AC-seitig und DC-seitig mit der zweiten Gehäusekammer verbunden, in der sich die Anschlusselemente befinden. Wie bereits ebenfalls an anderer Stelle dargelegt, ist die Kammer, die die leistungselektronischen Bauteile aufnimmt, insbesondere vor Feuchtigkeit nach der Schutzartklasse IP65 zu schützen. Insofern ist sicherzustellen, dass auch die elektrische Verbindung zwischen der ersten und der zweiten Gehäusekammer zumindest die Schutzartklasse aufweist, die die erste Gehäusekammer besitzt, im vorliegenden Fall beispielsweise mindestens die Schutzartklasse IP65.

Vorteilhafte Merkmale zu der Erfindung und besondere Ausführungsformen sind den Unteransprüchen zu entnehmen.

Es sind nun verschiedene Varianten denkbar, um insbesondere AC-seitig die Netzverbindung zwischen der ersten und der zweiten Kammer durch die dazwischen bestehende Wandung zu gestalten. Nach einer Variante ist vorgesehen, dass die elektrische Verbindung eine Kabeldurchführung umfasst. In diesem Fall ist weiterhin vorgesehen, dass die erste Gehäusekammer, die die leistungselektronischen Bauteile aufweist, zum Anschluss des Kabels zum Netz eine Netzanschlussklemme besitzt.

Nach einer weiteren Variante der Erfindung ist vorgesehen, dass die elektrische Verbindung eine Steckerbuchse umfasst, die in der Wandung zur ersten Gehäusekammer angeordnet ist, wobei die Steckerbuchse der Aufnahme eines Steckers mit dem Netzkabel dient.

Nach einer weiteren Variante ist als elektrische Verbindung eine Durchführungsklemme vorgesehen, die in der Wandung zur ersten Gehäusekammer angeordnet ist. Die Ausbildung einer solchen Durchführungsklemme mit der Schutzartklasse IP65 ist auch Gegenstand der Erfindung. Um demzufolge beispielsweise in Bezug auf eine Durchführungsklemme die Dichtigkeit nach der Schutzartklasse IP65 zu gewährleisten, ist vorgesehen, dass die Durchführungsklemme einen Klemmenkörper aufweist, wobei der Klemmenkörper einen Schild zur Anlage an der Wandung der ersten Gehäusekammer aufweist, wobei der Klemmenkörper ein Spannglied aufweist, durch welches der Klemmenkörper mit dem Schild an die Wandung der Gehäusekammer gedrückt wird. Hieraus wird deutlich, dass durch das Spannglied bei der Montage der Schild des Klemmenkörpers an die Wandung herangezogen wird, wodurch die erforderliche Dichtigkeit im Bereich des Übergangs von der einen zweiten Kammer in die andere erste Kammer gewährleistet wird. Vorteilhaft ist hierbei weiterhin vorgesehen, dass das Schild eine umlaufende Dichtung aufweist, mit der das Schild an der Wandung anliegt.

In Bezug auf das Spannglied ist vorteilhaft eine Spange vorgesehen, die verschieblich von dem Klemmenkörper aufnehmbar ist. Hierbei ist die Spange insbesondere nach Art eines U-förmigen Bügels ausgebildet, wobei der Schenkel des Bügels in der Seitenansicht auf den Bügel in Richtung auf den Steg des Bügels konisch sich erweiternd ausgebildet ist. Das bedeutet, je weiter die Spange auf den Klemmenkörper aufgeschoben wird, umso mehr wird der Klemmenkörper mit dem Schild und der daran befindlichen umlaufenden Dichtung an die Wandung herangezogen.

Im Einzelnen ist für die verschiebliche Aufnahme des Bügels durch den Klemmenkörper vorgesehen, dass der Klemmenkörper für die Schenkel des Bügels schienenartige Aufnahmen aufweist, wobei an dem von dem Schild abgewandten Teil an der schienenartigen Aufnahme jeweils eine Anlagekante für den Bügel vorgesehen ist, wobei die Anlagekante schräg zulaufend entsprechend der Ausbildung der Schenkel des Bügels ausgebildet ist. Durch diese Anlagekante wird erreicht, dass der Bügel bzw. auch die Spange während ihrer Aufsitzbewegung auf den Klemmenkörper kontinuierlich an die auf der einen Seite des Bügels befindliche Wandung herangezogen wird und so - wie bereits ausgeführt - das Schild an die Wandung angedrückt wird. Zur Sicherung der Spange auf dem Klemmenkörper sind entsprechende Rastmittel vorgesehen.

Anhand der Zeichnungen wird die Erfindung nachstehend beispielhaft näher erläutert.
- Figur 1: zeigt schematisch das Gehäuse des Wechselrichters mit den beiden abgenommenen Deckeln für die beiden Gehäusekammern;
- Figur 2: zeigt einen Ausschnitt aus der Wandung zwischen der ersten und zweiten Gehäusekammer, wobei an der Wandung eine Steckerbuchse zur Aufnahme eines Netzanschlusssteckers vorgesehen ist;
- Figur 3: zeigt eine Darstellung gemäß Figur 1, wobei in der Wandung eine Durchführungsklemme vorgesehen ist sowie in der ersten Gehäusekammer eine Netzanschlussklemme;
- Figur 4: zeigt die Durchführungsklemme gemäß Figur 3 in einer Seitenansicht;
- Figur 5: zeigt einen Schnitt gemäß der Linie V - V aus Figur 4 über die gesamte Breite der Durchführungsklemme in vergrößerter Darstellung;
- Figur 6: zeigt den Bügel 40 in einer Seitenansicht;
- Figur 7: zeigt den Schnitt gemäß der Linie VII-VII aus Figur 4 in entsprechend vergrößerter Darstellung wie Fig. 4.

Das Gehäuse 1 des Wechselrichters besitzt die beiden Kammern 2 und 3, wobei die erste Kammer 2 die leistungselektronischen Bauteile 4 zeigt, die in der ersten Gehäusekammer 2 lediglich angedeutet sind. Die beiden Gehäusekammern 2 und 3 sind durch die Wandung 5 getrennt. Die Wandung 5 weist allerdings weitere Steckerelemente 6 auf, die DC-seitig die Verbindung mit den PV-Modulen zu den leistungselektronischen Bauteilen (nicht dargestellt) in der Kammer 2 herstellen. AC-seitig ist ein Netzkabel 7 vorgesehen, das durch die Wandung 5 aus der zweiten Gehäusekammer 3 in die erste Gehäusekammer 2 geführt wird. In der ersten Gehäusekammer 2 befindet sich die Netzanschlussklemme 8, die die einzelnen Litzen des Kabels 7 aufnimmt. Die Kabeldurchführung 10 durch die Wandung 5 weist hierbei die Schutzartklasse IP65 auf, da auch die erste Gehäusekammer 2 nach dieser Schutzartklasse gegen Umwelteinflüsse, und hier insbesondere gegen Feuchtigkeit geschützt ist. Das heißt, der Deckel 2a, der die erste Gehäusekammer 2 abdeckt, weist eine Dichtung auf, so dass die erste Gehäusekammer in Bezug auf den Schutz vor Umwelteinflüssen der Schutzartklasse IP65 zuzuordnen ist. Der zweite Deckel 3a deckt die Gehäusekammer 3 ab, wobei als Besonderheit zu vermerken ist, dass der Deckel 2a Laschen 2b zeigt, von denen eine der Aufnahme einer Schraube 2c dient, die in die Wandung 5 stirnseitig von oben eingeschraubt wird und so der Fixierung des Deckels 2a auf der ersten Gehäusekammer 2 dient. Wesentlich ist nun, dass der Deckel 3a diese Laschen 2b mit der Schraube 2c abdeckt und so zunächst der Deckel 3a abgenommen werden muss, bevor die Gehäusekammer 2 geöffnet werden kann. Dies dient der zusätzlichen Sicherheit, um den Installateur davor zu bewahren, aus Gedankenlosigkeit auch die erste Gehäusekammer zu öffnen, wenn dies nicht notwendig ist.

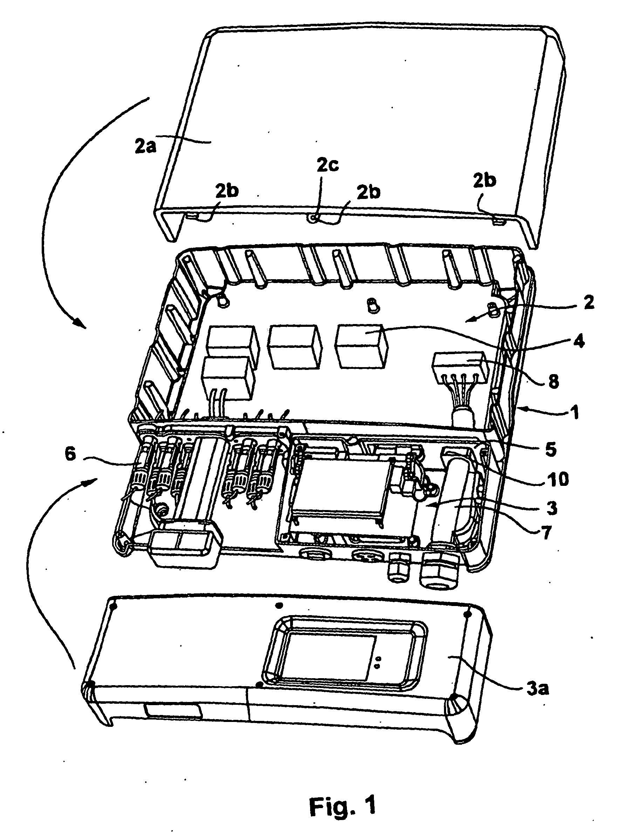

Wie bereits an anderer Stelle erläutert, ist in Figur 1 die Kabeldurchführung 10 der Schutzartklasse IP65 zuzuordnen.

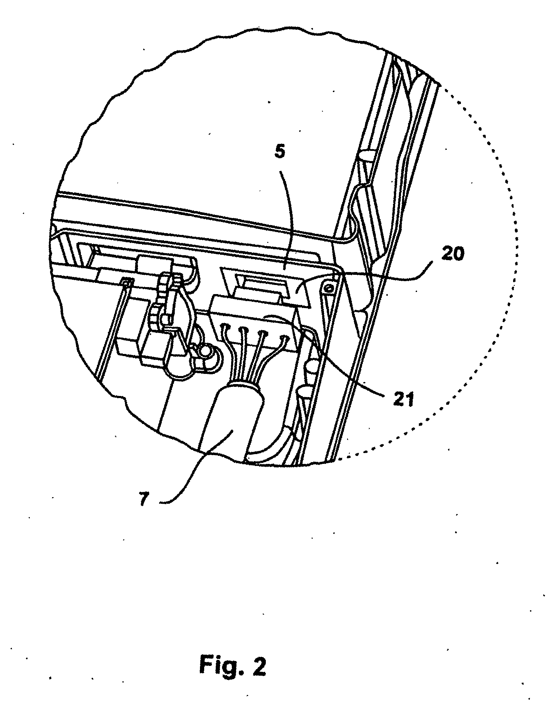

Gemäß Figur 2 ist als Variante einer Anbindung des Netzkabels an die Leistungselektronik eine Steckerbuchse 20 in der Wandung 5 vorgesehen, wobei die Steckerbuchse 20 ebenfalls der Schutzartklasse IP65 zuzuordnen ist. Der mit 21 bezeichnete Stecker des Netzkabels 7 wird von der Steckerbuchse 20 aufgenommen.

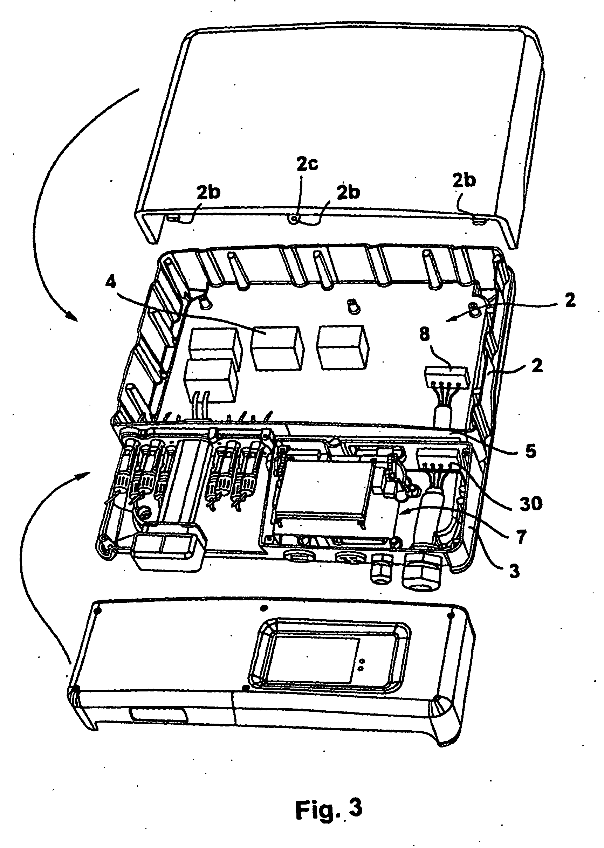

Gemäß Figur 3 ist als weitere Variante einer Anbindung des Netzkabels an die Leistungselektronik in der Wandung 5 eine Durchführungsklemme 30 angeordnet, die auf der einen Seite, d. h. der Gehäusekammer 3 zugeordnet, Anschlüsse für das Netzkabel 7 aufweist. In der Gehäusekammer 2 befindet sich dann wiederum eine Netzanschlussklemme 8, die durch die einzelnen Litzen des Kabels aufgenommen wird.

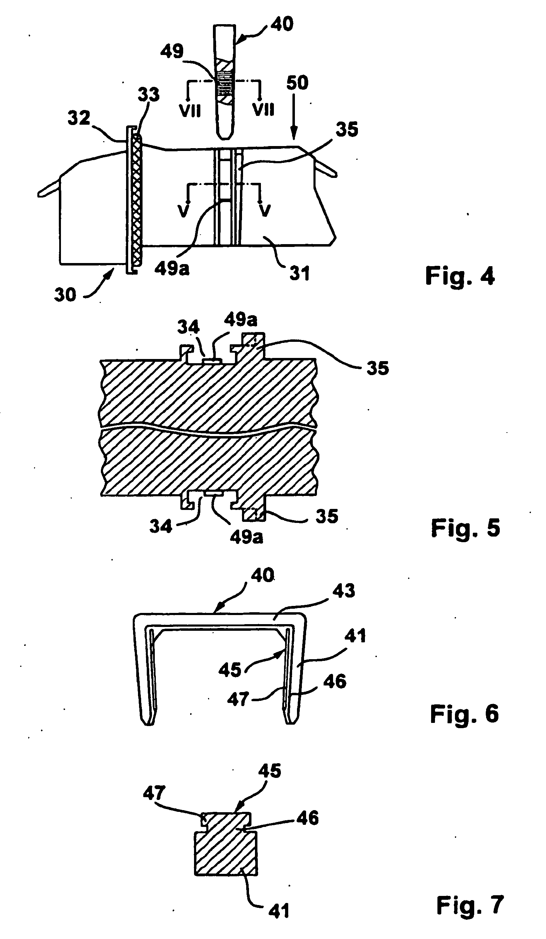

Gegenstand der Figuren 4 bis 7 ist nun die Ausbildung der Durchführungsklemme 30. Die mit 30 bezeichnete Durchführungsklemme besitzt den Klemmenkörper 31 sowie das Schild 32 mit der umlaufenden Dichtung 33. Mit dem Schild liegt die Durchführungsklemme 30 an der Wandung 5 zwischen den beiden Gehäusekammern 2 und 3 an. Der Klemmenkörper 31 besitzt zu beiden Seiten schienenartige Aufnahmen 34 (Figur 5) in Form von Schwalbenschwanzführungen, wobei im Bereich der schienenartigen Aufnahme 34 eine Anlagekante 35 vorgesehen ist. Der mit 40 bezeichnete U-förmige Bügel (Figur 6), der aus den beiden Schenkeln 41 und dem die Schenkel verbindenden Steg 43 besteht, weist an seinem Schenkel 41 eine T-förmige Gestaltung 45 auf mit einem Führungsschenkel 46 und einem quer dazu verlaufenden Führungssteg 47, die mit der schienenartigen Aufnahme in Form einer Schwalbenschanzführung 34 korrespondiert und zwar derart, dass der Bügel 40 mit seinem Schenkel 41 verschieblich von der schienenartigen Aufnahme 34 aufnehmbar ist. Während des Einschiebens des Bügels 40 in Richtung des Pfeils 50 gemäß Figur 4 gelangt aufgrund der Konizität der Schenkel 41 (Figur 4) und der Anlage der Schenkel 41 an der Anlagekante 35, der Bügel 40 immer mehr in Richtung des Schildes 32. Hieraus wird deutlich, dass das Schild 32 mit der Dichtung 33 immer stärker, d.h. je weiter der Bügel 40 auf den Klemmenkörper aufgeschoben ist, an die Wandung 5, die in der Figur 4 nicht dargestellt ist, herangedrückt wird. Um den Bügel 40 auf dem Klemmenkörper 31 zu fixieren, sind zwischen dem Schenkel 41 des Bügels 40 und dem Klemmenkörper Rastelemente 49, 49a in Form von Rastnasen vorgesehen, die rastend ineinander greifen.

## Patentansprüche

1. Wechselrichter für eine PV-Anlage, umfassend ein Gehäuse (1),
**dadurch gekennzeichnet,**
**dass** das Gehäuse (1) mindestens zwei Gehäusekammern (2, 3) umfasst, die durch jeweils einen gesonderten Deckel (2a, 3a) verschließbar sind,
wobei eine erste Gehäusekammer (2) die leistungselektronischen Bauteile (4) aufnimmt, wobei in die erste Gehäusekammer (2) von zumindest einer zweiten Gehäusekammer (3) mindestens eine elektrische Verbindung (108; 20, 21; 30, 8) vorgesehen ist, die eine Schutzartklasse aufweist, die mindestens der der ersten Gehäusekammer (2) entspricht wobei zunächst der Deckel (3a) der zweiten Gehäusekammer abgenommen werden muss, bevor die erste Gehäusekammer (2) geöffnet werden kann.

2. Wechselrichter nach Anspruch 1,
**dadurch gekennzeichnet,**
**dass** die elektrische Verbindung mindestens eine Kabeldurchführung (10) umfasst.

3. Wechselrichter nach Anspruch 2,
**dadurch gekennzeichnet,**
**dass** die erste Gehäusekammer (2) zum Anschluss eines Kabels eine Netzanschlussklemme (8) aufweist.

4. Wechselrichter nach Anspruch 1,
**dadurch gekennzeichnet,**
**dass** die elektrische Verbindung eine Steckerbuchse (20) umfasst, die in der Wandung (5) zur der ersten Gehäusekammer (2) angeordnet ist,
wobei die Steckerbuchse (20) der Aufnahme eines Steckers (21) dient.

5. Wechselrichter nach Anspruch 1,
**dadurch gekennzeichnet,**
**dass** die elektrische Verbindung eine Durchführungsklemme (30) umfasst, die in der Wandung (5) zu der ersten Gehäusekammer (2) angeordnet ist.

6. Wechselrichter nach Anspruch 5,
**dadurch gekennzeichnet,**
**dass** die Durchführungsklemme (30) einen Klemmenkörper (31) aufweist, wobei der Klemmenkörper (31) ein Schild (32) zur Anlage an die Wandung (5) der ersten Gehäusekammer (2) aufweist, wobei der Klemmenkörper (31) ein Spannglied (40) aufweist, durch welches der Klemmenkörper (31) mit dem Schild (32) an die Wandung (5) gedrückt wird.

7. Wechselrichter nach Anspruch 6,
**dadurch gekennzeichnet,**
**dass** das Spannglied (40) als Spange ausgebildet ist, die verschieblich von dem Klemmenkörper (31) aufnehmbar ist.

8. Wechselrichter nach Anspruch 7,
**dadurch gekennzeichnet,**
**dass** die Spange (40) nach Art eines U-förmigen Bügels ausgebildet ist, wobei die Schenkel (41) des Bügels (40) in der Seitenansicht auf den Bügel (40) in Richtung auf den Steg (43) des Bügels (40) konisch sich erweiternd ausgebildet sind.

9. Wechselrichter nach Anspruch 7,
**dadurch gekennzeichnet,**
**dass** zur verschieblichen Aufnahme des Bügels (40) durch den Klemmenkörper (31) der Klemmenkörper (31) für die Schenkel (41) des Bügels (40) schienenartige Aufnahmen (34) aufweist, wobei an dem von dem Schild (32) abgewandten Teil an der schienenartige Aufnahme (34) jeweils eine Anlagekante (35) für den Bügel (40) vorgesehen ist, wobei die Anlagekante (35) schräg zulaufend entsprechend der Ausbildung des Schenkels (43) des Bügels (40) am Klemmenkörper (31) ausgerichtet ist.

10. Wechselrichter nach Anspruch 7,
**dadurch gekennzeichnet,**
**dass** der Bügel (40) rastend auf dem Klemmenkörper (31) fixierbar ist.

11. Wechselrichter nach Anspruch 6,
**dadurch gekennzeichnet,**
**dass** das Schild (32) auf seiner der Wandung (5) zugewandten Seite eine Dichtung (33) aufweist.

12. Wechselrichter nach Anspruch 1,
**dadurch gekennzeichnet,**
**dass** durch die elektrische Verbindung die leistungselektronischen Bauteile (4) AC-seitig mit dem Netz verbunden sind.

## Claims

1. DC-AC converter for a photovoltaic installation, comprising a housing (1), **characterised in that** the housing (1) comprises at least two housing chambers (2, 3) which are each closable by a separate cover (2a, 3a), wherein a first housing chamber (2) receives the electronic power components (4), wherein at least one electrical connection (108; 20, 21; 30, 8) from at least one second housing chamber (3) is provided in the first housing chamber (2) and has a protective system category corresponding at least with that of the first housing chamber (2) and wherein the cover (3a) of the second housing chamber has to firstly be removed before the first housing chamber (2) can be opened.

2. DC-AC converter according to claim 1, **characterised in that** the electric connection comprises at least one cable feed-through (10).

3. DC-AC converter according to claim 2, **characterised in that** the first housing chamber (2) has a mains connecting terminal (8) for connection of a cable.

4. DC-AC converter according to claim 1, **characterised in that** the electrical connection comprises a socket (20) arranged in the wall (5) with respect to the first housing chamber (2), wherein the socket (20) serves for reception of a plug (21).

5. DC-AC converter according to claim 1, **characterised in that** the electrical connection comprises a feed-through terminal (30) arranged in the wall (5) with respect to the first housing chamber (2).

6. DC-AC converter according to claim 5, **characterised in that** the feed-through terminal (30) comprises a terminal body (31), wherein the terminal body (31) has a panel (32) for contact with the wall (5) of the first housing chamber (2), wherein the terminal body (31) has a clamping element (40) by which the terminal body (31) is pressed by the panel (32) against the wall (5).

7. DC-AC converter according to claim 6, **characterised in that** the clamping element (40) is constructed as a clasp receivable by the clamping body (31) to be displaceable.

8. DC-AC converter according to claim 7, **characterised in that** the clasp (40) is constructed in the manner of a U-shaped yoke (40), wherein the limbs (41) of the yoke (40) in side view of the yoke (40) are constructed to conically widen in direction towards the web (43) of the yoke (40).

9. DC-AC converter according to claim 7, **characterised in that** for displaceable reception of the yoke (40) by the clamping body (31) the clamping body (31) has rail-like receptacles (34) for the limbs (41) of the yoke (40), wherein a respective contact edge (35) for the yoke (40) is provided at the part, which is remote from the panel (32), of each rail-like receptacle (34), wherein the contact edge (35) is oriented at the terminal body (31) to run at an inclination in correspondence with the construction of the limb (43) of the yoke (40).

10. DC-AC converter according to claim 7, **characterised in that** the yoke (40) is fixable on the terminal body (31) by detenting.

11. DC-AC converter according to claim 6, **characterised in that** the panel (32) has a seal (33) on its side facing the wall (5).

12. DC-AC converter according to claim 1, **characterised in that** the electronic power components (4) are connected at the AC side with the mains by the electrical connection.

## Revendications

1. Onduleur pour une installation photovoltaïque, comprenant un boîtier (1),
**caractérisé en ce que**
le boîtier (1) comporte au moins deux chambres de boîtier (2, 3) qui peuvent chacune être fermée par un couvercle séparé (2a, 3a), une première chambre de boîtier (2) contenant les composants électroniques de puissance (4), au moins une connexion électrique (108; 20, 21; 30, 8) qui mène d'au moins une seconde chambre de boîtier (3) à la première chambre de boîtier (2) et qui présente une classe de protection correspondant au moins à celle de la première chambre de boîtier (2) étant prévu, et dans lequel il est nécessaire d'enlever au moins le couvercle (3a) de la seconde chambre du boîtier avant de pouvoir ouvrir la première chambre de boîtier (2).

2. Onduleur selon la revendication 1,
**caractérisé en ce que**
la connexion électrique comprend au moins une traversée de câble (10).

3. Onduleur selon la revendication 2,
**caractérisé en ce que**
la première chambre de boîtier (2) comporte une borne de connexion au réseau (8), qui est prévue pour le branchement d'un câble.

4. Onduleur selon la revendication 1,
**caractérisé en ce que**
la connexion électrique comprend une prise femelle (20) qui est disposée dans la paroi (5) voisine de la première chambre de boîtier (2), la prise femelle (20) servant à recevoir une fiche mâle (21).

5. Onduleur selon la revendication 1,
**caractérisé en ce que**
la connexion électrique comprend une borne de traversée (30) qui est disposée dans la paroi (5) voisine de la première chambre de boîtier (2).

6. Onduleur selon la revendication 5,
**caractérisé en ce que**
la borne de traversée (30) comporte un corps de borne (31), le corps de borne (31) comportant un flasque (32) destiné à être appuyé contre la paroi (5) de la première chambre de boîtier (2), le corps de borne (31) comportant un élément de serrage (40) par lequel le corps de borne (31) est pressé avec son flasque (32) contre la paroi (5).

7. Onduleur selon la revendication 6,
**caractérisé en ce que**
l'élément de serrage (40) est constitué par une agrafe qui peut être engagée par coulissement dans le corps de borne (31).

8. Onduleur selon la revendication 7,
**caractérisé en ce que**
l'agrafe (40) est réalisée à la façon d'un étrier en forme de U, dans une vue de côté de l'étrier (40), les branches (41) de l'étrier (40) étant configurées en s'élargissent de façon conique en direction de la branche transversale (43) de l'étrier (40).

9. Onduleur selon la revendication 7,
**caractérisé en ce que**
pour que l'étrier (40) soit engagé par coulissement dans le corps de borne (31), ce corps de borne (31) comporte des logements (34) en forme de rails pour les branches (41) de l'étrier (40), un rebord d'appui (35) pour l'étrier (40) étant prévu le long de chaque logement en forme de rail (34) sur la partie qui est éloignée du flasque (32), le rebord d'appui (35) étant orienté sur le corps de borne (31) en se rapprochant obliquement d'une façon qui correspond à la configuration de la branche (43) de l'étrier (40).

10. Onduleur selon la revendication 7,
**caractérisé en ce que**
l'étrier (40) peut être immobilisé sur le corps de borne (31) par encliquetage.

11. Onduleur selon la revendication 6,
**caractérisé en ce que**
le flasque (32) comporte une garniture d'étanchéité (33) sur son côté dirigé vers la paroi (5).

12. Onduleur selon la revendication 1,
**caractérisé en ce que**
les composants électroniques de puissance (4) sont reliés au réseau sur leur côté courant alternatif par la connexion électrique.
